# EUROPEAN PATENT APPLICATION

(11) **EP 4 845 316 A1**
(43) Date of publication of application: **25.11.2026**
(21) Application number: 26174635.8
(22) Date of filing: 25.04.2026
(51) Int. Cl.: H05K 1/181, H05K 3/303

(54) **METHOD AND CONFIGURATION FOR STACKING COMPONENTS ON PRINTED CIRCUIT BOARD (PCB)**

(30) Priority: 20.05.2025 IN 202511048623
(71) Applicant: Vertiv Corporation, Westerville, OH 43082 (US)
(72) Inventor: BHINTADE, Rahul, 411046 Pune, Maharashtra (IN); PATIL, Nitin, 412105 Pune, Maharashtra (IN)
(74) Representative: Bryn-Jacobsen, Caelia

(57) **Abstract**

The present invention relates to a Printed Circuit Board (PCB) assembly configured for space-efficient electronic integration using a stacked component architecture. The PCB assembly includes a PCB **200** with conductive tracks and solder pads, on which a first electronic component **202** is positioned using existing surface mount or through-hole soldering techniques. A second electronic component **204** is positioned vertically above the first electronic component **202** in a stacked configuration. Electrical connections for the first electronic component **202** and the second electronic component **204** are established with the PCB **200** via a first conductive pathway and a second conductive pathway respectively. This vertical arrangement minimizes horizontal space consumption, increases PCB density, and eliminates the need for additional boards or connectors.

## Description

### TECHNICAL FIELD

The present invention generally relates to Printed Circuit Board (PCB). More specifically, the present invention relates to a method and configuration for stacking electronic components on the PCB.

### BACKGROUND

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches, which in and of themselves may also correspond to implementations of the present technology.

Printed Circuit Boards (PCBs) are widely used in electronic assemblies to provide mechanical support and electrical interconnection for electronic components. In existing PCB manufacturing, components such as resistors, capacitors, diodes, and transistors are mounted on one or both surfaces of the PCB using surface mount technology or through-hole mounting techniques. Electrical connections are formed through conductive copper tracks and solder pads provided on the PCB, with component terminals soldered using solder paste, adhesives, and thermal processes such as reflow soldering or wave soldering. These techniques are commonly implemented using automated assembly equipment in high-volume production environments.

### SUMMARY OF THE INVENTION

This summary is provided to introduce examples related to an assembly for air filtration, and the examples are further described below in the detailed description. This summary is not intended to identify essential features of the present subject matter, nor is it intended for use in determining or limiting the scope of the present subject matter.

The present invention pertains to a Printed Circuit Board (PCB) assembly and an associated manufacturing approach for arranging electronic components in a stacked configuration on the PCB. In accordance with the invention, a first electronic component is mounted on a surface of the PCB, and a second electronic component is positioned over the first electronic component in a stacked arrangement. Each electronic component is electrically connected directly to the PCB through independent conductive pathways. The stacked configuration is implemented using established surface-mount assembly processes, including solder paste application, adhesive placement, and soldering operations, without requiring additional circuit boards or interconnecting structures.

The disclosed PCB assembly provides improved utilization of PCB area by enabling vertical placement of the electronic components while maintaining electrical isolation and direct electrical connectivity to the PCB. The stacked configuration allows higher component density within a given PCB layout without requiring additional printed circuit boards, connectors, or interconnecting structures. By reducing interconnect lengths and loop areas, the configuration supports improved signal integrity and reduced parasitic effects, including inductance and crosstalk, thereby contributing to improved electromagnetic interference (EMI) and electromagnetic compatibility (EMC) performance. The configuration further facilitates effective thermal management and is compatible with standard automated manufacturing processes, enabling compact, reliable, and manufacturable electronic assemblies.

In an example of the present disclosure, a Printed Circuit Board (PCB) assembly is disclosed. The PCB assembly comprises a first electronic component positioned over surface of the PCB. The first electronic component is electrically connected to the PCB via a first conductive pathway and a second electronic component positioned over surface of the first electronic component in a stacked configuration. The second electronic component is electrically connected to the PCB via a second conductive pathway. The first conductive pathway and second conductive pathway are established by applying at least one of solder paste and Surface Mount Device (SMD) adhesive on surface of the PCB, positioning the first electronic component on the surface of the PCB, subjecting the PCB to a reflow soldering operation to establish the first conductive pathway, applying at least one of solder paste and SMD adhesive on surface of the first electronic component positioning the second electronic component over the first electronic component in a stacked configuration and subjecting the PCB to the reflow soldering operation to establish the second conductive pathway.

In an example of the present disclosure, the first electronic component and the second electronic component comprise at least one of a resistor, a capacitor, a diode, and a transistor.

In another example of the present disclosure, the second electronic component is mechanically supported by a body of the first electronic component.

In another example of the present disclosure, the secondary component is electrically isolated from the first electronic component.

In another example of the present disclosure, the electrical isolation between the first electronic component and the second electronic component is maintained by at least one of physical spacing, lead orientation, lead bending, insulating sleeves, and conformal coating.

In another example of the present disclosure, the second electronic component includes terminals extending towards the PCB and configured to establish an electrical connection with corresponding solder pads or plated through holes of the PCB.

In another example of the present disclosure, the first conductive pathway and the second conductive pathway are further established by subjecting the PCB to a wave soldering operation.

In another example of the present disclosure, the stacked configuration is provided on only one side of the PCB.

In another example of the present disclosure, the stacked configuration is provided on both side of the PCB.

In another example of the present disclosure, the first electronic component and the second electronic component are mounted using Surface Mount Technology (SMT).

Other examples and advantages of the invention will become apparent from the following description, taken in conjunction with the accompanying drawings, illustrating by way of example the principles of the invention.

### BRIEF DESCRIPTION OF THE DRAWINGS

The accompanying figures of the drawing, which are included to provide a further understanding of general examples of the system/method, are incorporated in and constitute a part of this specification. These illustrative examples of the system/method, and together with the detailed description, explain the principles of the system. No attempt is made to show structural details in more detail than is necessary for a fundamental understanding of the system and various ways in which it is practiced. The following figures of the drawing include:
**Figs. 1a****,** **1b****,** and **1c** cumulatively illustrate examples of existing PCB implementations.
**Fig. 2** illustrates an implementation of stacked electronic components configuration on a Printed Circuit Board (PCB).
**Fig. 3** illustrates a flowchart of a method for stacking electronic components on one side (bottom side) of the PCB.
**Fig. 4** illustrates a manufacturing process for stacking electronic components on one side (bottom side) of the PCB.
**Fig. 5** illustrates a flowchart of a method for stacking electronic components on both sides of the PCB.
**Fig. 6** illustrates a manufacturing process for stacking electronic components on both sides of the PCB.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE INVENTION

Illustrative examples are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed examples. It is intended that the following detailed description be considered as exemplary only, with the true scope being indicated by the following claims.

Printed Circuit Boards (PCBs) form the foundational platform for mounting and interconnecting electronic components in modern electronic systems. In existing PCB assemblies, electronic components are typically arranged in a horizontal manner on one or both surfaces of the PCB using surface-mount or through-hole mounting techniques. Each component occupies a dedicated area on the PCB, and electrical interconnections are established through copper traces routed across the board. As the number and complexity of electronic components increase, this planar placement approach limits effective utilization of the available PCB surface area and often necessitates larger board dimensions or additional board-level arrangements.

Additionally, the spatial distribution of components in conventional PCB layouts results in increased interconnect lengths between components. Longer conductive paths can introduce parasitic effects such as inductance and capacitance, increase the likelihood of crosstalk between adjacent signals, and complicate electromagnetic interference (EMI) and electromagnetic compatibility (EMC) control, particularly in high-frequency or high-density designs. Existing layouts may also impose constraints on airflow and heat dissipation, thereby influencing thermal behavior and assembly considerations during manufacturing.

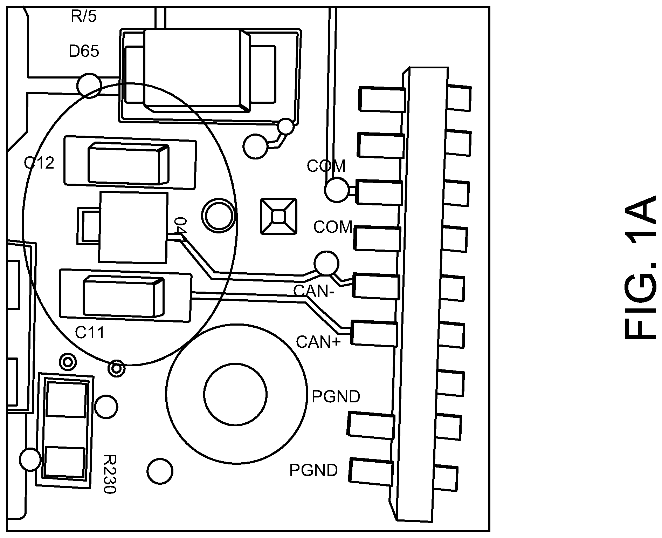

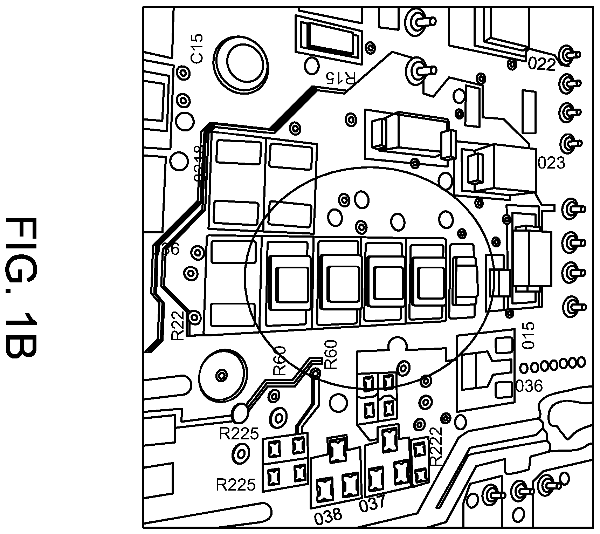

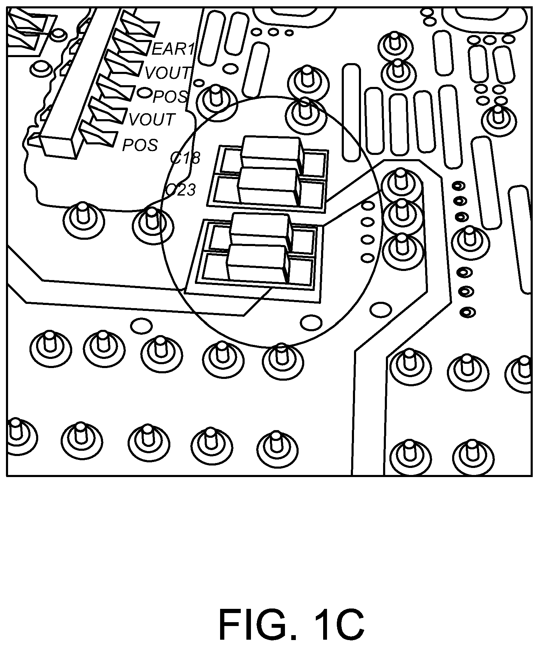

**Figs. 1a****,** **1b****,** and **1c** cumulatively illustrate examples of existing PCB implementations, highlighting the limitations mentioned above. **Fig. 1a** shows a typical layout involving a combination of different electronic components such as resistors, capacitors, and other discrete components placed adjacent to one another. **Fig. 1b** focuses on the layout of a discrete resistor and **Fig. 1c** similarly illustrates the placement of a capacitor in existing layout, reinforcing the same inefficiencies. Such figures clearly show that the horizontal arrangement of the electronic components leads to an underutilization of space and longer routing paths, which contribute to electrical and thermal inefficiencies.

To address the above considerations, the present invention provides a PCB assembly and corresponding configuration in which electronic components are arranged in a stacked manner on the PCB. In the disclosed configuration, a first electronic component is mounted on the PCB and a second electronic component is positioned over the first electronic component in a stacked arrangement, with each component being electrically connected directly to the PCB through separate conductive pathways. The configuration is implemented using established surface-mount manufacturing techniques and supports stacked placement on one or both sides of the PCB, thereby providing a structured and manufacturable approach to electronic component integration.

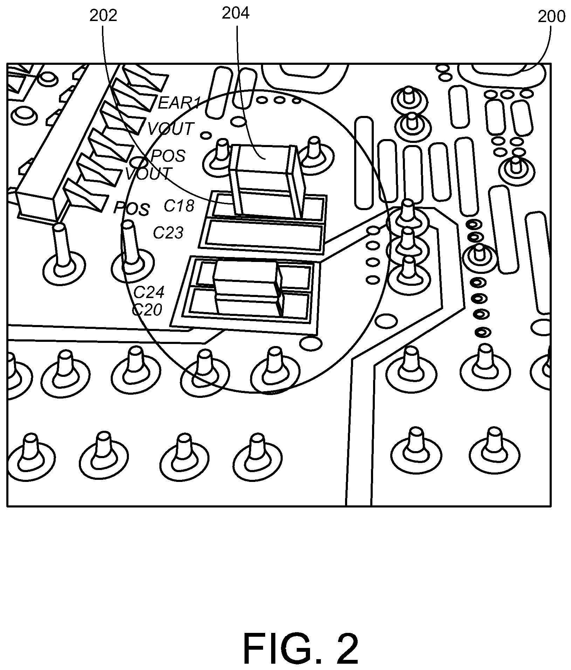

**Figure 2** illustrates an implementation of stacked electronic components configuration on a Printed Circuit Board (PCB) **200.** As shown, in the **Figure 2****,** The PCB **200** may serve as base platform for positioning various electronic components. The PCB **200** may include conductive copper tracks and solder pads for establishing electrical connections and mechanical stability with the electronic components. In one implementation, a first electronic component **202** may be positioned directly onto surface of the PCB **200.** The first electronic component **202** may include, but not limited to any passive or active device, such as a resistor, capacitor, diode, or transistor, which is electrically and mechanically secured to the PCB **200** using existing Surface Mount Technology (SMT) or through-hole soldering techniques. The terminals or leads of the first electronic component **202** may be aligned with predefined solder pads or plated through holes (vias) on the PCB **200** and are soldered to establish a first conductive pathway. The first conductive pathway may enable electrical current to flow between the first electronic component **202** and the rest of the circuit via the conductive copper tracks of the PCB **200.**

A second electronic component **204** may be positioned over the surface of the first electronic component **202** in a vertical stacked configuration. The second electronic component **204** may be placed in such a manner that it rests upon or above the body of the first electronic component **202,** effectively utilizing the vertical space above the PCB **200** that is typically left unused in existing mounting techniques. Such vertical stacked configuration allows for a significant reduction in the overall footprint of the PCB **200** by eliminating the need to allocate separate horizontal space for the second electronic component **204.** The second electronic component **204** may include, but not limited to any passive or active device, such as a resistor, capacitor, diode, or transistor, which is electrically and mechanically secured to the PCB **200** using existing SMT or through-hole soldering techniques.

In one implementation, the configuration of the stacked components may be designed to ensure electrical isolation between the first electronic component **202** and the second electronic component **204,** despite their close physical proximity. Additionally, the leads or terminals of the second electronic component **204** may be positioned and oriented in such a manner that they do not physically or electrically touch the conductive terminals of the first component. Adequate spacing, lead bending, and the use of insulating sleeves or conformal coatings, where required, further contribute to minimizing the risk of short circuits between the stacked components. Such careful mechanical and electrical design ensures safe and reliable operation of the stacked assembly.

In one implementation, the terminals or leads of the second electronic component **204** may be elongated and bent downward so that they reach the surface of the PCB **200,** where the terminals or leads of the second electronic component **204** are soldered to corresponding pads present on the PCB **200** forming a second conductive pathway. The second conductive pathway may enable electrical current to flow between the second electronic component **204** and the rest of the circuit via the conductive copper tracks of the PCB **200.** Such connection ensures that the second electronic component, although physically positioned over the first electronic component **202,** is electrically linked directly to the PCB circuit. In this arrangement, the body of the first electronic component **202** may serves as a support platform but does not interfere with the electrical path of the second electronic component **204.**

The first electronic component **202** and second electronic component **204** although positioned in close proximity vertically, may not electrically interconnected with each other unless specifically required by the circuit design. Each component is independently connected to the PCB **200** to ensure proper functioning and avoid unwanted electrical coupling or short circuits. Physical insulation, spacing, and careful orientation of terminals are maintained to ensure electrical isolation and manufacturability.

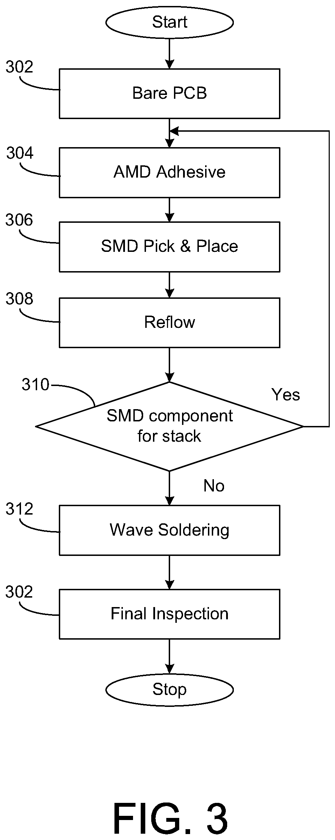

**Figure 3** illustrates a flowchart of a method **300** for stacking electronic components on one side (bottom side) of the PCB **200.** In this regard, each block may represent a module, segment, or portion of code, which comprises one or more executable instructions for implementing the specified logical function(s). It should also be noted that in some alternative implementations, the functions noted in the blocks may occur out of the order noted in the drawings. For example, two blocks shown in succession in **Figure 3** may in fact be executed substantially concurrently or the blocks may sometimes be executed in the reverse order, depending upon the functionality involved. Any process descriptions or blocks in flow charts should be understood as representing modules, segments, or portions of code which include one or more executable instructions for implementing specific logical functions or steps in the process, and alternate implementations are included within the scope of the examples in which functions may be executed out of order from that shown or discussed, including substantially concurrently or in reverse order, depending on the functionality involved. In addition, the process descriptions or blocks in flow charts should be understood as representing decisions made by a hardware structure such as a state machine.

At step **302,** the process begins with the preparation of a bare PCB. The bare PCB serve as the foundational substrate upon which the electronic components are positioned over. The PCB typically comprises layers of insulating material laminated with conductive copper tracks that define the electrical routing. The PCB includes pre-patterned solder pads and plated through holes (vias), which are used for both electrical connections and mechanical anchoring of various components. At this initial stage, the PCB is free of any electronic components and is ready to undergo surface preparation and adhesive application.

At step **304,** Surface Mount Device (SMD) adhesive is selectively dispensed onto the surface of the PCB at predefined component locations. The SMD adhesive is generally a thermosetting polymer that temporarily secures the electronic components during handling and before the soldering operation. The SMD adhesive is applied using stencil printing or automated dispensing equipment to ensure precise placement and volume control. Such step is crucial for stabilizing the electronic components during highspeed placement and during the thermal cycles of reflow or wave soldering.

At step **306,** the pick-and-place operation is performed, where first electronic component is positioned directly onto the surface of the PCB at the adhesive-applied positions. The first electronic component may include but not limited to resistors, capacitors, transistors, diodes, or other passive or active devices. Automated pick-and-place machines use vision-guided robotic arms to accurately pick each component from a reel or tray and place it on the board in the designated location. The terminals or leads of the first electronic component are aligned with the pre-defined solder pads or vias on the PCB to ensure a proper electrical interface.

At step **308,** the PCB is subjected to a reflow soldering process. In this step, the PCB is passed through a temperature-controlled oven where the PCB is gradually heated to a peak temperature sufficient to cure the adhesive and melt any solder paste (if applied). The heat generated from the oven causes the SMD adhesive hardens and forms a rigid mechanical bond between the first electronic component and the surface of the PCB. Such thermal setting ensures that the components are mechanically secured in their designated positions, maintaining precise alignment and placement during subsequent processes such as wave soldering.

At step **310,** the process encounters a decision point to determine whether the first electronic component is intended to support a stacked configuration. If no second electronic component is to be added, the process advances to the next stage. However, if stacking is required, the method loops back to step **304,** where SMD adhesive is again dispensed, this time on the top surface of the first electronic component. The stacking configuration involves positioning a second electronic component directly above or resting upon the first electronic component, creating a vertical stacked arrangement. The second electronic component is also connected electrically to the PCB, through its elongated terminals or leads that extend down to the pads on the PCB. Here if stacking is required, the step **304,** step **306** and step **308** are repeated in loop.

Once the stacking is complete, the process moves to step **312,** where wave soldering is performed. During this step, the bottom side of the PCB is passed over a controlled wave of molten solder generated in a solder bath. Such wave contacts all exposed metal terminals or leads both from first and second electronic components and the PCB pads simultaneously, creating uniform solder joints. The wave soldering ensures high-reliability mechanical and electrical connections for all components, regardless of whether they are placed directly on the board or stacked. The wave soldering results in forming the first conductive path way for the first electronic component which enable electrical current to flow between the first electronic component and the rest of the circuit via the conductive copper tracks of the PCB. The wave soldering further results in forming the second conductive pathway for the second electronic component. The second conductive pathway enable electrical current to flow between the second electronic component and the rest of the circuit via the conductive copper tracks of the PCB.

At step **314,** a final inspection is conducted to verify the integrity and correctness of the entire PCB assembly. Inspection methods may include manual visual checks, automated optical inspection (AOI), X-ray inspection, or functional electrical testing. This step identifies defects such as cold joints, solder bridges, misalignment, insufficient solder fill, or damage to the components. PCB that fail inspection may flagged for rework or rejection, while successful assemblies move forward in the production process.

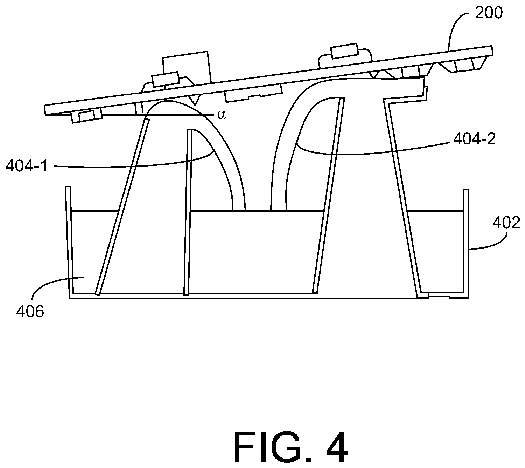

**Figure 4** illustrates a manufacturing process for stacking electronic components on one side (bottom side) of the PCB **200.** In one implementation, the PCB **200** enters the conveyor system of a wave soldering machine **402.** The PCB **200** may be already populated with certain electronic components, such as a first electronic component **202** positioned directly onto surface of the PCB **200** and second electronic component **204** positioned over the surface of the first electronic component **202.** The PCB **200** is placed on conveyor belts (**404-1, 404-2**) typically inclined at a small angle (say inclination α), which facilitates uniform flow of molten solder across the surface of the PCB **200** and allows for effective drainage of excess solder after processing.

Beneath the moving conveyor belts (**404-1, 404-2**), a solder pot **406** containing a molten solder alloy, commonly composed of tin-lead or a lead-free alternative is maintained at a controlled temperature. The solder pot **406** is pumped to generate a continuous standing wave of molten solder, which interacts with the underside of the PCB **200** during its transit. The wave soldering unit generally produces two distinct solder wave profiles that perform separate functions in the soldering process.

The first solder wave is a pre-wave characterized by turbulent wave flow. As the PCB **200** passes over the turbulent wave, the motion of the solder ensures penetration into plated through-holes and beneath component leads. This turbulence aids in breaking surface oxides and allows the previously applied flux to activate the metal surfaces. This enhances the wettability of the surfaces and prepares them for optimal solder adhesion, especially at the solder pads or vias corresponding to the first electronic component **202** mounted directly on the PCB **200** and second electronic component **204** positioned over the surface of the first electronic component **202.**

The PCB **200** then proceeds to the main solder wave, which exhibits laminar flow characteristics. Such smooth and stable wave evenly distributes molten solder across the underside of the PCB **200,** thereby forming uniform and reliable solder joints. During this stage, molten solder makes direct contact with the exposed leads or terminals of the first electronic component **202.** It may also flow into any plated through-holes, creating solid electrical and mechanical connections to the internal copper tracks of the PCB.

In the context of the present invention, where components are stacked in a vertical configuration, such process further includes the handling of second electronic component **204** that is positioned over the surface of the first electronic component **204.** These second electronic component **204** may be mechanically supported by the body of the first electronic component **202.** The design ensures that only the exposed connections at the base (e.g., the terminals of the first electronic component **202** or elongated leads of the second electronic component **204**) interact with the solder wave, while upper-level components remain unaffected by the molten solder. In some implementations, adhesives or physical placement strategies are employed to prevent undesirable solder bridging or overheating of upper components during wave soldering. After the interaction of the terminals or leads of the first electronic component **202** and the second electronic component **204** with the solder wave it forms the first conductive pathway and the second conductive pathway for creating the electrical connections of the electronic components with the PCB **200.**

After passing through the solder wave, the PCB **200** exits the conveyer system and enters a cooling phase where the solder joints begin to solidify. This results in robust electrical and mechanical connections between the components and the PCB **200.** Finally, the assembled PCB **200** undergoes a post-wave inspection process. This inspection ensures solder quality, detects any potential short circuits, and confirms the structural integrity and alignment of the stacked components. Special emphasis is placed on verifying that the vertical stacking of components does not lead to mechanical instability or unintended electrical connections, thus maintaining the reliability of the circuit.

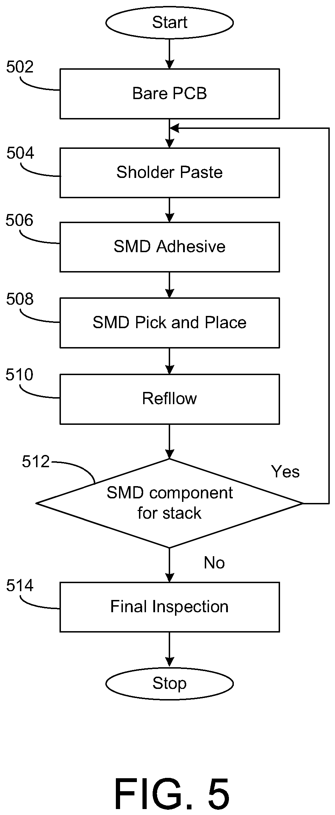

**Fig. 5** illustrates a flowchart of a method **500** for stacking electronic components on both side of the PCB **200.** In this regard, each block may represent a module, segment, or portion of code, which comprises one or more executable instructions for implementing the specified logical function(s). It should also be noted that in some alternative implementations, the functions noted in the blocks may occur out of the order noted in the drawings. For example, two blocks shown in succession in **Fig. 5** may in fact be executed substantially concurrently or the blocks may sometimes be executed in the reverse order, depending upon the functionality involved. Any process descriptions or blocks in flow charts should be understood as representing modules, segments, or portions of code which include one or more executable instructions for implementing specific logical functions or steps in the process, and alternate implementations are included within the scope of the examples in which functions may be executed out of order from that shown or discussed, including substantially concurrently or in reverse order, depending on the functionality involved. In addition, the process descriptions or blocks in flow charts should be understood as representing decisions made by a hardware structure such as a state machine.

At step **502,** the process begins with the provision of a bare PCB. The bare PCB refers to the base board structure, fabricated with etched copper conductive tracks, via holes, solder pads, and insulating substrate materials such as FR4. At this stage, the PCB does not contain any components. The layout of the PCB is designed to accommodate both standard and stacked surface-mount electronic components, including necessary provisions for routing and thermal management.

At step **504,** solder paste is applied to specific solder pad locations on the bottom surface of the PCB. This is typically done using a stainless-steel stencil aligned over the PCB, allowing solder paste to be deposited only on designated solder pad areas. The solder paste, which is a combination of flux and fine solder alloy particles, serves the dual role of securing the SMD components temporarily and forming the final electrical connections during the reflow process. The paste ensures that the component leads bond effectively to the copper pads when subjected to high temperatures in later steps.

At step **506,** an SMD adhesive is applied at selective locations near or beneath certain component footprints on both side of the PCB. The purpose of such adhesive is to provide additional mechanical stability to the electronic components during the reflow process, especially when the PCB is being conveyed through the heating zones of the reflow oven. In implementations involving stacked components, the adhesive helps hold the first electronic component firmly in place, and may also assist in supporting the second component in the vertical stack. The SMD adhesive is typically dispensed as small dots using automated dispensers and is designed to withstand the temperatures involved in reflow soldering.

At step **508,** SMDs are mounted onto both sides of the PCB using automated pick-and-place machines. Such machines are programmed to accurately position a variety of electronic components including resistors, capacitors, integrated circuits, and stacked assemblies onto the designated areas prepared with the solder paste and the SMD adhesive on the top and bottom surfaces of the PCB. The process supports two scenarios: standard placement directly on the PCB surface and stacked placement where the second electronic component is positioned on top of the first electronic component. For stacked configurations, the second electronic component is placed in alignment such that the terminals or leads of the second electronic component extend to the underlying PCB pads. This step ensures spatial optimization and proper interconnect planning across both PCB surfaces, while maintaining alignment critical to high-reliability assemblies.

At step **510,** the dual-sided PCB undergoes the reflow soldering process. The board is conveyed through a reflow oven programmed with a thermal profile designed to solder components on both sides simultaneously or in a staged sequence, depending on the specific reflow setup (e.g., double-sided reflow with adhesive support). As the temperature increases through preheat, soak, and reflow zones, the solder paste melts and forms strong metallurgical bonds between the component terminals or leads and the corresponding copper pads on the PCB. Simultaneously, the SMD adhesive cures and hardens, ensuring that components especially those on the underside remain fixed in place and do not shift due to gravity or convection during heating. The reflow soldering process result in forming the first conductive path way for the first electronic component which may enable electrical current to flow between the first electronic component and the rest of the circuit via the conductive copper tracks of the PCB.

At step **512,** a decision point is reached to determine whether additional SMD components need to be stacked. If stacking is required, the process loops back to step **504.** This loop allows for the selective application of solder paste and adhesive over an already-mounted first electronic component, followed by pick-and-place placement of the second electronic component and reflow processing. The loop can be executed for one or more stacked levels, depending on the system design and the thermal/mechanical tolerances of the components used. This iterative stacking capability enables vertical integration on both sides of the PCB without increasing board footprint. The reflow soldering process further forms the second conductive pathway for the second electronic component that enable electrical current to flow between the second electronic component and the rest of the circuit via the conductive copper tracks of the PCB.

If no further stacking is required, the process proceeds to step **514,** where a final inspection is carried out. Quality assurance checks are conducted to verify component alignment, solder joint integrity, absence of bridging or open circuits, and stability of stacked structures. Inspection is particularly critical for double-sided and vertically stacked configurations, where the risk of shadowing, thermal misalignment, or unsupported joints is higher. Both automated optical inspection (AOI) systems and manual checks may be used to ensure compliance with assembly tolerances.

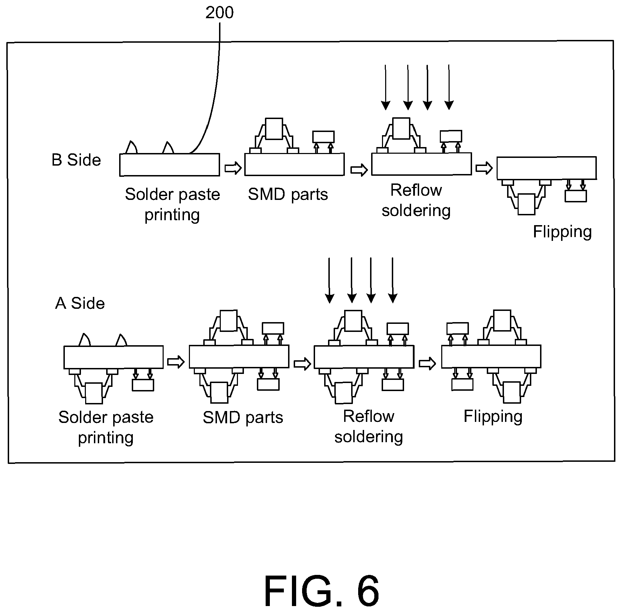

**Fig. 6** illustrates a manufacturing process for stacking electronic components on both sides of the PCB **200.** In one implementation a bare PCB **200** is loaded into the stencil printing station, where a layer of solder paste is applied to the B side pads. This paste, a mixture of finely powdered solder alloy and flux, serves as the bonding medium during reflow. Following paste application, a pick-and-place machine positions SMDs onto the B side. Such components may include not only the first electronic component placed directly onto the PCB but also the second electronic component positioned over the first electronic component in a stacked configuration. In such stacked configurations, the second component rests on top of the first and is electrically connected via downward-extending leads to the PCB **200.**

Once placement on the B side is completed, the PCB **200** enters a reflow oven. Controlled heat ramps the temperature, causing the solder paste to melt and form robust mechanical and electrical joints between the electronic components and the PCB. Importantly, when stacking is implemented, thermal profiles and adhesive supports are calibrated to ensure that both base and stacked components are held securely during solder reflow without positional shifts or tilt.

After reflow on the B side, the PCB **200** is cooled and flipped to expose the A side. A new stencil printing step applies solder paste to the top-side pads. Similar to the B side, the pick-and-place machine mounts both base and stacked components on the A side depending on the circuit design. Once all electronic components on the A side are placed, the PCB **200** is passed through the reflow oven for the second cycle. Although the previously processed B side is now facing downward, its solder joints remain stable due to solidified solder fillets and surface tension that resist gravitational pull. Meanwhile, the A side solder paste melts and forms bonds between the pads and the leads or terminals of both base and stacked components. The overall design of the stacking configuration ensures that both electrical connectivity and vertical mechanical stability are maintained through this thermal process.

After cooling, the PCB **200** undergoes a final inspection, including optical and automated quality checks. These inspections confirm the integrity of solder joints, the alignment of stacked components, and the structural stability on both sides. This dual-side stacking approach significantly enhances PCB density and layout efficiency while remaining compatible with SMT reflow processes.

The methods, systems, devices, graphs, and/or tables discussed herein are examples. Various examples may omit, substitute, or add various procedures or components as appropriate. For instance, in alternative examples, the methods may be performed in an order different from that described, and/or various stages may be added, omitted, and/or combined. Also, features described with respect to certain examples may be combined in various other examples. Different examples and elements of the examples may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred examples of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as a limitation on the scope of the disclosure.

Further examples are set out in the clauses below:
1. A Printed Circuit Board (PCB) assembly comprises:
   a PCB 200 having a plurality of conductive tracks configured to form electrical connections;
   a first electronic component 202 positioned over surface of the PCB 200; wherein the first electronic component 202 is electrically connected to the PCB 200 via a first conductive pathway; and
   a second electronic component 204 positioned over surface of the first electronic component 202 in a stacked configuration; wherein the second electronic component 204 is electrically connected to the PCB 200 via a second conductive pathway and
   wherein the first conductive pathway and second conductive pathway are established by:
      applying at least one of solder paste and Surface Mount Device (SMD) adhesive on surface of the PCB 200;
      positioning the first electronic component 202 on the surface of the PCB 200;
      subjecting the PCB 200 to a reflow soldering operation to establish the first conductive pathway;
      applying at least one of solder paste and SMD adhesive on surface of the first electronic component 202;
      positioning the second electronic component 204 over the first electronic component 202 in a stacked configuration; and
      subjecting the PCB 200 to the reflow soldering operation to establish the second conductive pathway.
2. The PCB assembly according to clause 1, wherein the first electronic component 202 and the second electronic component 204 comprises at least one of a resistor, a capacitor, a diode, and a transistor.
3. The PCB assembly according to clause 1 or clause 2, wherein the second electronic component 204 is mechanically supported by a body of the first electronic component 202.
4. The PCB assembly according to clause 3, wherein the secondary component 204 is electrically isolated from the first electronic component 202.
5. The PCB assembly according to clause 4, wherein the electrical isolation between the first electronic component 202 and the second electronic component 204 is maintained by at least one of physical spacing, lead orientation, lead bending, insulating sleeves, and conformal coating.
6. The PCB assembly according to any one of clauses 1 to 5, wherein the second electronic component 204 includes terminals extending towards the PCB 200 and configured to establish an electrical connection with corresponding solder pads or plated through holes of the PCB 200.
7. The PCB assembly according to any one of clauses 1 to 6, the first conductive pathway and the second conductive pathway are further established by subjecting the PCB 200 to a wave soldering operation.
8. The PCB assembly according to any one of clauses 1 to 7, wherein the stacked configuration is provided on only one side of the PCB 200.
9. The PCB assembly according to any one of clauses 1 to 8, wherein the stacked configuration is provided on both side of the PCB 200.
10. The PCB assembly according to any one of clauses 1 to 9, wherein the first electronic component 202 and the second electronic component 204 are mounted using Surface Mount Technology (SMT).

## Claims

1. A Printed Circuit Board, 'PCB', assembly comprises:
a PCB (200) having a plurality of conductive tracks configured to form electrical connections;
a first electronic component (202) positioned over surface of the PCB (200); wherein the first electronic component (202) is electrically connected to the PCB (200) via a first conductive pathway; and
a second electronic component (204) positioned over surface of the first electronic component (202) in a stacked configuration;
wherein the second electronic component (204) is electrically connected to the PCB (200) via a second conductive pathway; and
wherein the first conductive pathway and second conductive pathway are established by:
applying at least one of solder paste and Surface Mount Device, SMD, adhesive on surface of the PCB (200);
positioning the first electronic component (202) on the surface of the PCB (200);
subjecting the PCB (200) to a reflow soldering operation to establish the first conductive pathway;
applying at least one of solder paste and SMD adhesive on surface of the first electronic component (202);
positioning the second electronic component (204) over the first electronic component (202) in a stacked configuration; and
subjecting the PCB (200) to the reflow soldering operation to establish the second conductive pathway.

2. The PCB assembly according to claim 1, wherein the first electronic component (202) and the second electronic component (204) comprises at least one of a resistor, a capacitor, a diode, and a transistor.

3. The PCB assembly according to claim 1 or claim 2, wherein the second electronic component (204) is mechanically supported by a body of the first electronic component (202).

4. The PCB assembly according to claim 3, wherein the secondary component (204) is electrically isolated from the first electronic component (202).

5. The PCB assembly according to claim 4, wherein the electrical isolation between the first electronic component (202) and the second electronic component (204) is maintained by at least one of physical spacing, lead orientation, lead bending, insulating sleeves, and conformal coating.

6. The PCB assembly according to any one of claims 1 to 5, wherein the second electronic component (204) includes terminals extending towards the PCB (200) and configured to establish an electrical connection with corresponding solder pads or plated through holes of the PCB (200).

7. The PCB assembly according to any one of claims 1 to 6, the first conductive pathway and the second conductive pathway are further established by subjecting the PCB (200) to a wave soldering operation.

8. The PCB assembly according to any one of claims 1 to 7, wherein the stacked configuration is provided on only one side of the PCB (200).

9. The PCB assembly according to any one of claims 1 to 8, wherein the stacked configuration is provided on both side of the PCB (200).

10. The PCB assembly according to any one of claims 1 to 9, wherein the first electronic component (202) and the second electronic component (204) are mounted using Surface Mount Technology, 'SMT'.
